(19) Europäisches Patentamt
European Patent Office
Office européen des brevets

(11) EP 2 958 114 A1

(12) EUROPEAN PATENT APPLICATION
published in accordance with Art. 153(4) EPC

(43) Date of publication:
**23.12.2015 Bulletin 2015/52**

(21) Application number: **14751024.2**

(22) Date of filing: **06.02.2014**

(51) Int Cl.:
***H01B 3/30*** *(2006.01)* ***C08F 8/00*** *(2006.01)*
***C08F 290/12*** *(2006.01)* ***C08F 299/00*** *(2006.01)*
***C09D 11/00*** *(2014.01)* ***C09D 157/00*** *(2006.01)*
***H01B 3/44*** *(2006.01)* ***H01L 29/786*** *(2006.01)*
***H01L 51/05*** *(2006.01)* ***H01L 51/30*** *(2006.01)*

(86) International application number:
**PCT/JP2014/052745**

(87) International publication number:
**WO 2014/125990 (21.08.2014 Gazette 2014/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.02.2013 JP 2013024374**

(71) Applicant: **DIC Corporation**
**Tokyo 174-8520 (JP)**

(72) Inventors:
- **MINAKUCHI Ryo**
  **Sakura-shi**
  **Chiba 285-8668 (JP)**
- **SAKURAI Yoshinobu**
  **Sakura-shi**
  **Chiba 285-8668 (JP)**
- **OKAMOTO Tomoko**
  **Sakura-shi**
  **Chiba 285-8668 (JP)**

(74) Representative: **Beckmann, Claus**
**Kraus & Weisert**
**Patentanwälte PartGmbB**
**Thomas-Wimmer-Ring 15**
**80539 München (DE)**

# (54) RESIN COMPOSITION FOR INSULATING MATERIALS, INSULATING INK, INSULATING FILM AND ORGANIC FIELD EFFECT TRANSISTOR USING INSULATING FILM

(57) The present invention provides an insulating material which has a high curing rate as well as solvent resistance suitable for a printing method while having a high degree of breakdown strength as well as a low leak current density in order to improve the performance of an organic field effect transistor, and also provides an insulating film having the insulating material and a transistor. A resin composition for insulating materials contains a vinyl polymer, and the vinyl polymer has an acid value of 20 mgKOH/g or less, a (meth)acryloyl group equivalent of 220 to 1600 g/eq, and phenyl groups and (meth)acryloyl groups.

EP 2 958 114 A1

## Description

### Technical Field

The present invention relates to a resin composition for insulating materials, an insulating ink, an insulating film, and an organic field effect transistor using the insulating film.

### Background Art

Field effect transistors using insulating materials such as polysilicon, amorphous silicon, and the like use a chemical vapor deposition method and an oxidation method in a process for depositing a semiconductor layer and thus require large-scale equipment such as a vacuum apparatus, and the transistors are complicated and require many steps. Also, heating at 300°C to 1000°C is required in a process for crystallizing a semiconductor layer, and thus a substrate is required to have heat resistance.

On the other hand, field effect transistors using organic materials in semiconductor layers include films which can be formed by an application or printing method using a solution containing organic materials in a process for forming a semiconductor layer, and thus large-screen elements can be manufactured at low cost. In addition, the semiconductor layer can be produced by a low-temperature process at 200°C or less as compared with semiconductor layers using inorganic materials, and thus flexible plastic can be used as a substrate.

A bottom-gate type which is one of the element configurations of field effect transistors using organic materials for semiconductor layers includes an organic semiconductor layer laminated on a gate insulating layer. A voltage applied to a gate electrode acts on the semiconductor layer through the gate insulating film, thereby controlling ON/OFF of a drain current. Characteristics required for the gate insulating film include a high degree of breakdown strength and low leak current density for achieving the reliability of an element and solvent resistance for forming a layered-structure element.

In the industry, organic-inorganic hybrid materials having a siloxane bond, such as polysilsesquioxane, are currently used, and Patent Literature 1 discloses a silsesquioxane-based curable material. The material has excellent electric insulation and excellent solvent resistance. However, the curable material requires a long curing time, and printing formation cannot be performed within a short time, thereby increasing production cost.

On the other hand, Patent Literature 2 discloses a composition for a gate insulating layer of a field effect transistor, the composition capable of forming a gate insulating layer which is little eluted even when a semiconductor material is wet-applied on the insulating layer, the composition containing a polymerizable monomer, a polymerization initiator, and a resin having an allyl group and/or a (meth)acryloyl group as a cross-linkable group, the polymerizable monomer having 2 or more ethylenically unsaturated bonds, and the cross-linkable group-containing resin having a cross-linkable group equivalent of 800 g/eq or less. However, a resin of related art contains many alkali soluble groups of carboxylic acids or the like, and when an organic field effect transistor element is formed by using the resin, electrons/carriers of an upper-layer semiconductor are trapped by the alkali soluble groups of carboxylic acids in a cured thin-film surface. As a result, the leak current density of an element is increased, and transistor characteristics deteriorate with time, thereby sometimes decreasing the reliability of the element.

### Citation List

### Patent Literature

PTL 1: Japanese Unexamined Patent Application Publication No. 2009-059651
PTL 2: Japanese Unexamined Patent Application Publication No. 2012-195580

### Summary of Invention

### Technical Problem

A problem is to provide a resin composition for insulating materials, the resin composition having a high curing rate as well as solvent resistance suitable for a printing method while having a high degree of breakdown strength as well as a low leak current density in order to improve the performance of an organic field effect transistor, and also provide an insulating film having the resin composition for insulating materials and a transistor having good reliability.

Solution to Problem

That is, a resin composition for insulating materials, an insulating ink, an insulating film, and an organic field effect transistor using the insulating film according to the present invention are described below in [1] to [9].

[1] A resin composition for insulating materials containing a vinyl polymer which has an acid value of 20 mgKOH/g or less, a (meth)acryloyl group equivalent of 220 to 1600 g/eq, and phenyl groups and (meth)acryloyl groups.
[2] The resin composition for insulating materials described in [1], wherein the vinyl polymer is produced by reacting an epoxy group of a copolymer of a phenyl group-containing vinyl monomer (I) and an epoxy group-containing vinyl monomer (II) with a monomer (III) having a (meth)acryloyl group and a carboxyl group.
[3] The resin composition for insulating materials described in [1] or [2], wherein the weight-average molecular weight of the vinyl polymer is 3,000 to 200,000.
[4] A method for producing a resin composition for insulating materials containing a vinyl polymer, the method including a step of producing a copolymer by copolymerizing a phenyl group-containing vinyl monomer (I) with an epoxy group-containing vinyl monomer (II), and a step of reacting an epoxy group of the resultant copolymer with (meth)acrylic acid.
[5] An insulating ink containing the resin composition for insulating materials described in any one of [1] to [3].
[6] A cured product produced by curing the resin composition for insulating materials described in any one of [1] to [3].
[7] An insulating film for an organic field effect transistor, the insulating film produced by curing the resin composition for insulating materials described in any one of [1] to [3].
[8] The insulating film described in [7], wherein the insulating film is a gate insulating film.
[9] An organic field effect transistor including the insulating film described in [7].

Advantageous Effects of Invention

The present invention can provide a resin composition for insulating materials, the resin composition having a high curing rate as well as solvent resistance suitable for a printing method while having a high degree of breakdown strength as well as a low leak current density. Also the present invention can provide an insulating film having the resin composition for insulating materials and a transistor having good reliability.

Brief Description of Drawings

[Fig. 1] Fig. 1 is a drawing showing an example of a transistor.

[Fig. 2] Fig. 2 is a drawing showing an example of a transistor.

Description of Embodiments

(Vinyl polymer)

The present invention is characterized by providing a resin composition for insulating materials containing a vinyl polymer, the vinyl polymer used in the resin composition for insulating materials of the present invention having an acid value of 20 mgKOH/g or less, a (meth)acryloyl group equivalent of 220 to 1600 g/eq, and at least one phenyl group and at least one (meth)acryloyl group. (1) The acid value of as low as 20 mgKOH or less, and when an organic transistor is produced, trapping of electrons/carriers of a semiconductor is little influenced, thereby producing a good element having reliability of transistor characteristics. (2) The composition can be cured by active energy rays because it contains a (meth)acryloyl group, and thus a coating film with high solvent resistance can be easily formed by cross-linking reaction. (3) Because of a phenyl group present in a side chain, electric characteristics such as excellent breakdown strength and a low leak current density are excellent due to a benzene ring.
When the acid value is 20 mgKOH/g or less, a cured thin film has a hydrophobic surface because of few hydrophilic functional groups, and a field effect transistor has no influence of trapping of electrons/carriers of a semiconductor, thereby producing an element having good transistor characteristics and causing excellent solvent resistance. Therefore, the present invention is suitable for an element forming method. In particular, from the viewpoint of improving transistor characteristics, the acid value is preferably 10 or less and more preferably 5 or less.
The acid value represents a mg amount of potassium hydroxide required for neutralizing an acid content present in 1 g of sample. Specifically, the acid value can be measured by a method including dissolving a weighed sample in a

solvent at a volume ratio of toluene/methanol = 70/30, adding few droplets of a 1% phenolphthalein alcohol solution to the resultant solution, and confirming a point of color change by adding dropwise a 0.1 mol/L potassium hydroxide alcohol solution to the mixture. The acid value can be determined by a calculation formula below.

$$\text{Acid value (mgKOH/g)} = (V \times F \times 5.611)/S$$

V: Amount (mL) of 0.1 mol/L potassium hydroxide alcohol solution used
F: Titer of 0.1 mol/L potassium hydroxide alcohol solution
S: Amount (g) of sample collected
5.611: Potassium hydroxide equivalent (mg) in 1 mL of 0.1 mol/L potassium hydroxide alcohol solution

The vinyl polymer of the present invention can be produced by a known common method but can be preferably produced through is produced a step of copolymerizing a phenyl group-containing vinyl monomer (I) with an epoxy group-containing vinyl monomer (II) and a step of reacting an epoxy group of the resultant copolymer with a monomer (III) having a (meth)acryloyl group and a carboxyl group.

The copolymer of the vinyl monomer (I) and the epoxy group-containing vinyl monomer (II) generally has an epoxy group as a reactive group, and thus a cross-linked film can be formed by thermal curing with an acid anhydride or optical curing with a photoacid generator. However, the cross-linked film contains an acid such as a carboxylic acid or the like which traps electrons/carriers, and thus when the film is used as an insulating film of a field effect transistor element, there is the possibility of decreasing characteristics and reliability of the element. On the other hand, a polymer produced by reacting an epoxy group of the copolymer with the monomer (III) having a (meth)acryloyl group and a carboxyl group contains a (meth)acryloyl group as a reactive group, and thus cross-linking requires no acid, thereby causing good transistor characteristics.

Examples of the phenyl group-containing vinyl monomer include vinyl monomers below.

(1) Styrene and styrene derivatives such as styrene, α-methylstyrene, α-ethylstyrene, α-butylstyrene, 4-methylstyrene, chlorostyrene, and the like; and
(2) (meth)acrylic acid esters having an aromatic ring, such as bonzoyloxyethyl (meth)acrylate, benzyl (meth)acrylate, phenylethyl (meth)acrylate, phenoxyethyl (meth)acrylate, phenoxydiethyl glycol (meth)acrylate, 2-hydroxy-3-phenoxypropyl (meth)acrylate, and the like. These may be used alone or in combination of two or more. Among these, styrene and styrene derivatives are preferred because of a low leak current density.

The epoxy group-containing vinyl monomer is a vinyl monomer having a glycidyl group or an epoxy group, and a vinyl monomer is a monomer having a polymerizable unsaturated group such as a vinyl group, a (meth)acryloyl group, a maleimide group, a stylyl group, or the like. Examples of the epoxy group-containing vinyl monomer include glycidyl (meth)acrylate, glycidyl α-ethyl (meth)acrylate, glycidyl α-n-propyl (meth)acrylate, glycidyl α-n-butyl (meth)acrylate, 6,7-epoxypentyl (meth)acrylate, β-methylglycidyl (meth)acrylate, 3,4-epoxycyclohexyl (meth)acrylate, 3,4-epoxycyclohexyl lactone-modified (meth)acrylate, vinylcyclohexene oxide, and the like. These may be used alone or in combination of two or more. Among these, a monomer having a glycidyl group and a (meth)acryloyl group is preferred in view of a curing rate.

In preparing the polymer of the phenyl group-containing vinyl monomer and the epoxy group-containing vinyl monomer, the amount of the phenyl group-containing vinyl monomer used is 10 to 90 parts by weight, preferably 30 to 85 parts by weight. The amount of the epoxy group-containing vinyl monomer used is 10 to 90 parts by weight, preferably 15 to 70 parts by weight.

Besides the phenyl group-containing vinyl monomer and the epoxy group-containing vinyl monomer, a vinyl monomer copolymerizable with these monomers can be used in combination with the monomers. The amount of the other monomer used is generally 0 to 50 parts by weight and preferably 0 to 30 parts by weight. Examples of the other vinyl monomer include the following vinyl monomers.

(1) (Meth)acrylic acid esters having an alkyl group having 1 to 22 carbon atoms, such as methyl (meth)acrylate, ethyl (meth)acrylate, propyl (meth)acrylate, n-butyl (meth)acrylate, tert-butyl (meth)acrylate, hexyl (meth)acrylate, heptyl (meth)acrylate, octyl (meth)acrylate, nonyl (meth)acrylate, decyl (meth)acrylate, dodecyl (meth)acrylate, tetradecyl (meth)acrylate, hexadecyl (meth)acrylate, octadecyl (meth)acrylate, docosyl (meth)acrylate, and the like;
(2) (meth)acrylic acid esters having an alicyclic alkyl group, such as cyclohexyl (meth)acrylate, isobornyl (meth)acrylate, dicyclopentanyl (meth)acrylate, dicyclopentanyloxyethyl (meth)acrylate, and the like;

(3) (meth)acrylic acid esters having a hydroxyalkyl group, such as hydroxyethyl (meth)acrylate, hydroxypropyl (meth)acrylate, hydroxybutyl (meth)acrylate, glycerol (meth)acrylate, hydroxyethyl lactone-modified (meth)acrylate, (meth)acrylic acid esters having a polyalkylene glycol group, such as (meth)acrylic acid polyethylene glycol (meth)acrylate and polypropylene glycol (meth)acrylate, and the like;
(4) unsaturated dicarboxylic acid esters such as dimethyl fumarate, diethyl fumarate, dibutyl fumarate, dimethyl itaconate, dibutyl itaconate, methylethyl fumarate, methylbutyl fumarate, methylethyl itaconate, and the like;
(5) diene compounds such as butadiene, isoprene, piperylene, dimethylbutadiene, and the like;
(6) halogen-based vinyl and vinylidene halides such as vinyl chloride, vinyl bromide, and the like;
(7) unsaturated ketones such as methyl vinyl ketone, butyl vinyl ketone, and the like;
(8) vinyl esters such as vinyl acetate, vinyl butyrate, and the like;
(9) vinyl ethers such as methyl vinyl ether, butyl vinyl ether, and the like;
(10) vinyl cyanides such as acrylonitrile, methacrylonitrile, vinylidene cyanide, and the like;
(11) N-substituted maleimides such as N-phenyl maleimide, N-cyclohexyl maleimide, and the like;
(12) fluorine-containing ethylenically unsaturated monomers, such as fluorine-containing $\alpha$-olefins such as vinyl fluoride, vinylidene fluoride, trifluoroethylene, chlorotrifluoroethylene, bromotrifluoroethylene, pentafluoropropylene, hexafluoropropylene, and the like; (per)fluoroalkyl perfluorovinyl ethers having a (per)fluoroalkyl group having 1 to 18 carbon atoms, such as trifluoromethyl trifluorovinyl ether, pentafluoroethyl trifluorovinyl ether, pentafluoropropyl trifluorovinyl ether, and the like; (per)fluoroalkyl (meth)acrylates having a (per)fluoroalkyl group having 1 to 18 carbon atoms, such as 2,2,2-trilfluoroethyl (meth)acrylate, 2,2,3,3-tetrafluoropropyl (meth)acrylate, 1H,1H,5H-octafluoropentyl (meth)acrylate, 1H,1H,2H,2H-heptadecafluorodecyl (meth)acrylate, perfluoroethyloxyethyl (meth)acrylate, and the like;
(13) silyl group-containing (meth)acrylates such as $\gamma$-methacryloxypropyl trimethoxysilane and the like;
(14) N,N-dialkylaminoalkyl (meth)acrylates such as N,N-dimethylaminoethyl (meth)acrylate, N,N-diethylaminoethyl (meth)acrylate, N,N-diethylaminopropyl (meth)acrylate, and the like; and
(15) acrylic acid esters having an amide group, such as acrylamide and the like.

These other vinyl monomers used for preparing the polymer of the phenyl group-containing vinyl monomer and the epoxy group-containing vinyl monomer may be used alone or in combination or two or more.

The polymer of the phenyl group-containing vinyl monomer and the epoxy group-containing vinyl monomer may be produced by polymerization (copolymerization) using a known commonly-used method, and a polymerization mode is not particularly limited. The polymer can be produced by addition polymerization in the presence of a catalyst (polymerization initiator), and the copolymer may be any one of a random copolymer, a block copolymer, a graft copolymer, and the like. A known polymerization method such as a block polymerization method, a solution polymerization method, a suspension polymerization method, an emulsion polymerization method, or the like can be used as a copolymerization method.

Typical examples of a solvent which can be used in solution polymerization or the like include ketone solvents such as acetone, methyl ethyl ketone, methyl-n-propyl ketone, methyl isopropyl ketone, methyl-n-butyl ketone, methyl isobutyl ketone, methyl-n-amyl ketone, methyl-n-hexyl ketone, diethyl ketone, ethyl-n-butyl ketone, di-n-propyl ketone, diisobutyl ketone, cyclohexanone, phorone, and the like;
ether solvents such as ethyl ether, isopropyl ether, n-butyl ether, diisoamyl ether, ethylene glycol dimethyl ether, ethylene glycol diethyl ether, diethylene glycol dimethyl ether, diethylene glycol, dioxane, tetrahydrofuran, and the like;
ester solvents such as ethyl formate, propyl formate, n-butyl formate, ethyl acetate, n-propyl acetate, isopropyl acetate, n-butyl acetate, n-amyl acetate, ethylene glycol monomethyl ether acetate, ethylene glycol monoethyl ether acetate, diethylene glycol monomethyl ether acetate, diethylene glycol monoethyl ether acetate, propylene glycol monomethyl ether acetate, ethyl-3-ethoxypropionate, and the like;
alcohol solvents such as methanol, ethanol, isopropyl alcohol, n-butyl alcohol, isobutyl alcohol, diacetone alcohol, 3-methoxy-1-propanol, 3-methoxy-1-butanol, 3-methyl-3-methoxybutanol, and the like; and
hydrocarbon solvents such as toluene, xylene, Solvesso 100, Solvesso 150, Swasol 1800, Swasol 310, Isopar E, Isopar G, Exxon Naphtha No. 5, Exxon Naphtha No. 6, and the like. These may be used alone or in combination or two or more. However, in order to efficiently perform the second step of reaction of the epoxy group-containing vinyl monomer with a carboxyl group-containing monomer or reaction of a carboxyl group-containing vinyl monomer with an epoxy group-containing monomer, the reaction is preferably performed at a high temperature of 100°C to 150°C. From this viewpoint, the solvent having a boiling point of 100°C or more and preferably 100°C to 150°C is preferably used.

In addition, a catalyst which is generally known as a radical polymerization initiator can be used as the catalyst, and examples thereof include azo compounds such as 2,2'-azobisisobutyronitrile, 2,2'-azobis-(2,4-dimethylvaleronitrile), 2,2'-azobis-(4-methoxy-2,4-dimethylvaleronitrile), and the like; organic peroxides such as benzoyl peroxide, lauroyl peroxide, tert-butylperoxy pivalate, tert-butylperoxyethyl hexanoate, 1,1'-bis-(tert-butylperoxy)cyclohexane, tert-amylperoxy-2-ethyl hexanoate, tert-hexylperoxy-2-ethyl hexanoate, and the like; hydrogen peroxide, and the like.

When a peroxide is used as the catalyst, a redox-type initiator may be used by using the peroxide together with a reducing agent.

The vinyl polymer of the present invention can be produced by reacting the copolymer of the phenyl group-containing vinyl monomer and the epoxy group-containing vinyl monomer produced as described above with a monomer having a (meth)acryloyl group and a carboxyl group. Examples of the monomer having a (meth)acryloyl group and a carboxyl group include unsaturated monocarboxylic acids having an ester bond, such as (meth)acrylic acid, β-carboxyethyl (meth)acrylate, 2-acryloyloxyethyl succinate, 2-acryloyloxyethyl phthalate, 2-acryloyloxyethyl hexahydrophthalate, and lactone-modified products thereof, and the like. Also, a carboxyl group-containing polyfunctional (meth)acrylate monomer produced by reacting an acid anhydride such as succinic anhydride or maleic anhydride with a hydroxyl group-containing polyfunctional (meth)acrylate monomer such as pentaerythritol triacrylate or the like may be used. These monomers each having a (meth)acryloyl group and a carboxyl group may be used alone or in combination of two or more. Among these, (meth)acrylic acid is preferred in view of the solvent resistance of a cured film.

The reaction of the polymer of the phenyl group-containing vinyl monomer and the epoxy group-containing vinyl monomer with the monomer having a (meth)acryloyl group and a carboxyl group is generally performed by mixing both components with a catalyst such as triphehylphosphine, a quaternary ammonium salt, or the like, and heating the mixture at about 80°C to 120°C. The amounts of the polymer and monomer used are not particularly limited, but the number of moles of carboxyl groups in the monomer having a (meth)acryloyl group and a carboxyl group is preferably 0.4 to 1.0 mole per mole of epoxy group.

When the vinyl polymer of the present invention is used in combination with a reactive compound such as polyfunctional (meth)acrylate, the (meth)acryloyl group equivalent of the vinyl polymer of the present invention is preferably 220 to 1600 g in order to form a coating film having high solvent resistance.

When the vinyl polymer of the present invention is used alone, the (meth)acryloyl group equivalent is preferably 220 to 600 g/eq in order to form a coating film having high solvent resistance by cross-linking reaction using active energy rays.

The weight-average molecular weight of the vinyl polymer of the present invention is preferably 3,000 to 200,000. This is because with the weight-average molecular weight of 3,000 or more, a smooth thin film can be formed due to excellent leveling property, while with the weight-average molecular weight of 200,000 or less, both the solubility in organic solvents and stability are excellent. From this viewpoint, the weight-average molecular weight is more preferably 5,000 to 100,000.

As described above, the vinyl polymer of the present invention can be produced by

1. the step of copolymerizing the phenyl group-containing vinyl monomer (I) with the epoxy group-containing vinyl monomer (II) by a solution polymerization method to produce the copolymer, and
2. the step of adding the monomer (III) having a (meth)acryloyl group and a carboxyl group to an epoxy group of the resultant copolymer to effect reaction. This method is preferred because the acid value of the vinyl polymer can be easily adjusted by adjusting the amount of the monomer (III) having a (meth)acryloyl group and a carboxyl group added.

When the vinyl polymer of the present invention has an acid value of 20 mgKOH/g or less, the vinyl polymer can be produced by another synthesis method and, for example, may be produced by

3. the step of reacting the phenyl group-containing vinyl monomer (I) with a vinyl monomer (III') having a carboxyl group by a solution polymerization method to produce a copolymer, and
4. the step of adding a monomer (II') having a (meth)acryloyl group and an epoxy group to a carboxyl group of the resultant copolymer to effect reaction.

Also, in the vinyl polymer of the present invention, a hydroxyl group produced by reacting an epoxy group with a carboxylic acid group may be sealed by acetylation or urethanation. This enables proper adjustment of the (meth)acryloyl equivalent and can decrease the amount of hydroxyl groups in the vinyl polymer and decrease polarity, and thus can improve the transistor characteristics.

Examples of a monomer used for acetylation include acetyl compounds such as acetyl chloride, acetic anhydride, and the like.

A method for acetylation reaction of hydroxyl groups in the vinyl polymer of the present invention is not particularly limited, and a known method can be used. Specifically, for example, an acetylation reagent may be added dropwise to the vinyl polymer of the present invention and reacted by heating at 50°C to 120°C. The amounts of the vinyl polymer and acetylation reagent used are not limited, but, generally, hydroxyl groups in the vinyl polymer (mole):acetylation reagent (mole) = 1:0.1 to 1:1.1.

Examples of a monomer having an isocyanate for performing urethanation include compounds below.

Examples of an aliphatic monoisocyanate include phenyl isocyanate, p-tolyl isocyanate, and 1-naphthyl isocyanate. Examples of an aliphatic monoisocyanate include tert-butyl isocyanate, ethyl isocyanate, propyl isocyanate, hexyl isocyanate, and the like. Also, a monomer having an isocyanate and a (meth)acryloyl group may be used. Specific examples thereof include Karenz (registered trade name) AOI, Karenz MOI, Karenz BEI (trade name, manufactured by Showa Denko K.K.), a reaction adduct of a diisocyanate compound and hydroxyacrylate, and the like.

A method for reacting the vinyl polymer of the present invention with a monomer having an isocyanate is not particularly limited, and a known method can be used. Specifically, for example, a monomer having an isocyanate may be added dropwise to the vinyl polymer of the present invention and reacted by heating at 50°C to 120°C. The amounts of the vinyl polymer and monomer having an isocyanate used are not limited, but, generally, hydroxyl groups in the vinyl polymer (mole):isocyanate group in the monomer having an isocyanate (mole) = 1:0.1 to 1:1.1.

[Resin composition for insulating materials]

The resin composition for insulating materials of the present invention contains the vinyl polymer. The resin composition for insulating materials of the present invention preferably contains a polymerization initiator. A photopolymerization initiator or thermpolymerization initiator can be used as the polymerization initiator according to a curing method.

[Photopolymerization initiator]

A photopolymerization initiator generally known for photocurable resin compositions may be used as the photopolymerization initiator, and, for example, at least one selected from the group consisting of acetophenones, oxime esters, acylphosphine oxides, benzylketals, and benzophenones can be preferably used. The acetophenones include diethoxyacetophenone, 2-hydroxy-2-methy-1-phenylpropan-1-one, 1-(4-isopropylphenyl)-2-hydroxy-2-methylpropan-1-one, 4-(2-hydroxyethoxy)phenyl-(2-hydroxy-2-propyl) ketone, 2-hydroxycyclohexyl-phenyl ketone, 2-methy-1-(4-methylthiophenyl)-2-morpholinopropan-1-one(2-benzyl-2-dimethylamino-1-(4-morpholinophenyl)-butanone-1, and the like. The acylphosphine oxides include 2,4,6-trimethylbenzoyl)-diphenylphosphine oxide, bis(2,4,6-trimethylbenzoyl)-phenylphosphine oxide, and the like. The oxime esters include 2-(bonzoyloxyimino)-1-[4-(phenylthio)phenyl]-1-octanone and the like. Examples of the benzyl ketals include 2,2-dimethoxy-1,2-diphenylethan-1-one, benzyldimethyl ketal, and the like. Examples of the benzophenones include benzophenone, methyl o-benzoylbenzoate, and the like. Examples of the benzoins include benzoin, benzoin methyl ether, benzoin isopropyl ether, and the like. The photopolymerization initiators may be used along or in combination of two or more.

Examples of trade names of the photopolymerization initiator include Irgacure 651, Irgacure 184, Irgacure 819, Irgacure 907, Irgacure 1870, Irgacure 500, Irgacure 369, Darocur 1173, Irgacure 2959, Irgacure 4265, Irgacure 4263, Lucirin TPO, Irgacure OXEO1, and the like (manufactured by BASF Corporation).

The amount of the photopolymerization initiator used is preferably 1 to 15% by weight and more preferably 2 to 10% by weight relative to 100% by weight of the vinyl polymer.

In addition, photosensitivity can be significantly improved by using a sensitizing dye in combination with the photopolymerization initiator. Specific examples of the sensitizing dye include thioxanthene-based, xanthene-based, ketone-based, thiopyrylium salt-based, bisstyryl-based, merocyanine-based, 3-substituted coumarin-based, cyanine-based, acridine-based, and thiazine-based dyes.

[Thermopolymerization initiator]

A thermopolymerization initiator generally known as a radical polymerization initiator can be used as the thermopolymerization initiator, and examples thereof include azo compounds such as 2,2'-azobisisobutyronitrile, 2,2'-azobis-(2,4-dimethylvaleronitrile), 2,2'-azobis-(4-methoxy-2,4-dimethylvaleronitrile), and the like; organic peroxides such as benzoyl peroxide, lauroyl peroxide, tert-butylperoxy pivalate, 1,1'-bis-(tert-butylperoxy)cyclohexane, tert-amylperoxy-2-ethyl hexanoate, tert-hexylperoxy-2-ethyl hexanoate, and the like. These polymerization initiators can be used alone or in combination of two or more.

[Reactive compound]

The resin composition for insulating materials of the present invention may contain a reactive compound in addition to the vinyl polymer.

A polymer or monomer having a reactive group directly contributing to curing reaction with the vinyl polymer can be used as the reactive compound. In particular, a reactive diluent such as an active energy ray-curable monomer is preferred.

When the active energy ray-curable monomer is used as the reactive compound, if required, the composition may contain polyfunctional (meth)acrylate or monofunctional (meth)acrylate.

Example of the polyfunctional (meth)acrylate include polyfunctional (meth)acrylates each having 2 or more polymerizable double bonds per molecule, such as ethylene glycol di(meth)acrylate, 1,2-propanediol di(meth)acrylate, 1,4-butanediol di(meth)acrylate, 1,6-hexanediol di(meth)acrylate, dipropylene glycol di(meth)acrylate, neopentyl glycol di(meth)acrylate, tripropylene glycol di(meth)acrylate, trimethylolpropane di(meth)acrylate, trimethylolpropane tri(meth)acrylate, tris(2-(meth)acryloxyethyl) isocyanurate, pentaerythritol tri(meth)acrylate, pentaerythritol tetra(meth)acrylate, di(trimethylolpropane) tetra(meth)acrylate, di(pentaerythritol) penta(meth)acrylate, di(pentaerythritol) hexa(meth)acrylate, tricyclodecanedimethanol di(meth)acrylate, ethylene oxide-added bisphenol A di(meth)acrylate, ethylene oxide-added bisphenol F di(meth)acrylate, propylene oxide-added bisphenol A di(meth)acrylate, propylene oxide-added bisphenol F di(meth)acrylate, di(meth)acrylate having a 9,9-bisphenylfluorene skeleton, and the like.

Example of the monofunctional (meth)acrylate include hydroxyl group-containing (meth)acrylic acid esters such as hydroxyethyl (meth)acrylate, hydroxypropyl (meth)acrylate, hydroxybutyl (meth)acrylate, caprolactone-modified hydroxyl(meth)acrylate (for example, trade name "Placcel" manufactured by Daicel Chemical Industries Ltd.), mono(meth)acrylate of polyester diol produced from phthalic acid and propylene glycol, mono(meth)acrylate of polyester diol produced from succinic acid and propylene glycol, polyethylene glycol mono(meth)acrylate, polypropylene glycol mono(meth)acrylate, pentaerythritol mono(meth)acrylate, 2-hydroxy-3-(meth)acryloyloxypropyl (meth)acrylate, various epoxy ester (meth)acrylic acid adducts, and the like; carboxyl group-containing vinyl monomers such as (meth)acrylic acid, crotonic acid, itaconic acid, maleic acid, fumaric acid, and the like; sulfonate group-containing vinyl monomers such as vinylsulfonic acid, styrenesulfonic acid, sulfoethyl (meth)acrylate, and the like; acid phosphate-based vinyl monomers such as 2-(meth)acryloyloxyethyl acid phosphate, 2-(meth)acryloyloxypropyl acid phosphate, 2-(meth)acryloyloxy-3-chloro-propyl acid phosphate, 2-methacryloyloxyethylphenyl phosphate, and the like; methylol group-containing vinyl monomers such as N-methylol (meth)acrylamide and the like; zyl acrylate, benzyl (meth)acrylate, phenylbenzyl (meth)acrylate, phenoxybenzyl (meth)acrylate, phenol EO-modified (meth)acrylate, o-phenylphenol EO-modified (meth)acrylate, para-cumylphenol EO-modified (meth)acrylate, nonylphenol EO-modified (meth)acrylate, phthalic acid monohydroxethyl (meth)acrylate, 2-hydroxy-3-phenoxypropyl (meth)acrylate, 2-(phenylthio)ethyl (meth)acrylate, cyclohexyl (meth)acrylate, tetrahydrofurfuryl (meth)acrylate, dicyclopentenyl (meth)acrylate, dicyclopentenyloxyethyl (meth)acrylate, dicyclopentanyl (meth)acrylate, isoboronyl (meth)acrylate, adamantyl (meth)acrylate, and the like. These can be used alone or in combination of two or more.

When the polyfunctional and monofunctional acrylates are used, in view of the leveling property, the amount of use is preferably 0% to 80% by weight and more preferably 0% to 50% by weight relative to the total solid content of the resin composition for insulating materials of the present invention. By using the polyfunctional and monofunctional acrylates within this range, coating film hardness and solvent resistance can be adjusted.

[Insulating ink]

In order to apply the resin composition for insulating materials of the present invention to a coating method and a printing method, an insulating ink can be produced by adding a solvent, filler, a rheology adjusting agent, or the like to the resin composition so as to adjust ink viscosity and printability.

Any desired solvent can be used as an organic solvent of the insulating ink of the present invention as long as it dissolves the resin composition for insulating materials. Examples thereof include, but are not particularly limited to, aliphatic hydrocarbon organic solvents such as pentane, hexane, heptane, octane, decane, dodecane, isopentane, isohexane, isooctane, cyclohexane, methylcyclohexane, cyclopentane, and the like; aromatic hydrocarbon organic solvents such as benzene, toluene, o-xylene, m-xylene, p-xylene, ethylbenzene, mesitylene, tetralin, dichlorobenzene, chloronaphthalene, cyclohexylbenzene, diethylbenzene, and the like; ester solvents such as methyl formate, ethyl formate, propyl formate, methyl acetate, ethyl acetate, isopropyl acetate, n-propyl acetate, isobutyl acetate, n-butyl acetate, methyl propionate, ethyl propionate, and the like; alcohol solvents such as methanol, ethanol, propanol, isopropanol, sec-butanol, tert-butanol, cyclohexanol, $\alpha$-terpineol, and the like; ketone solvents such as acetone, methyl ethyl ketone, methyl isobutyl ketone, cyclohexanone, 2-hexanone, 2-heptanone, 2-octanone, and the like; alkylene glycol solvents such as diethylene glycol ethyl ether, diethylene glycol diethyl ether, propylene glycol monomethyl ether, propylene glycol monoethyl ether, propylene glycol monopropyl ether, propylene glycol monobutyl ether, propylene glycol monomethyl ether acetate, diethylene glycol methyl ether acetate, diethylene glycol ethyl ether acetate, diethylene glycol propyl ether acetate, diethylene glycol isopropyl ether acetate, diethylene glycol butyl ether acetate, diethylene glycol tert-butyl ether acetate, triethylene glycol methyl ether acetate, triethylene glycol ethyl ether acetate, triethylene glycol propyl ether acetate, triethylene glycol isopropyl ether acetate, triethylene glycol butyl ether acetate, triethylene glycol tert-butyl ether acetate, dipropylene glycol dimethyl ether, dipropylene glycol monobutyl ether, and the like; ether solvents such as diethyl ether, dipropyl ether, diisopropyl ether, dibutyl ether, dihexyl ether, ethyl vinyl ether, butyl vinyl ether, anisol, butyl phenyl ether, pentyl phenyl ether, methoxytoluene, benzyl ethyl ether, diphenyl ether, dibenzyl ether, dioxane,

furan, tetrahyrofuran, and the like; and amide solvents such as N,N-dimethylformamide, N,N-dimethylacetamide, N-methylpyrrolidone, and the like. These may be used alone or in combination of two or more.

(Compounding material)

Other compounding materials may be added to the insulating ink of the present invention within a range where the effect of the present invention is not impaired. From the viewpoint of viscosity adjustment, storage stability, and surface tension adjustment, an organic filler such as polymer fine particles, an inorganic filler such as silica inorganic oxide particles, a pigment, an antioxidant, a polymerization inhibitor, a surfactant, a rheology adjusting agent, and the like may be properly used.

[Insulating film]

The resin composition for insulating materials or insulating ink of the present invention can be cured to produce a cured product which can be used as an insulating film. For example, the insulating film can be formed by developing the resin composition for insulating materials of the present invention on a substrate and then curing the resin composition. In order to form the insulating film, the resin composition for insulating materials of the present invention is directly developed by application, coating, printing, or the like on a substrate on which the film is desired to be formed. Also, an insulating film may be formed on another substrate or a mold, cured, and then used as an insulating film for various electronic members. The resin composition for insulating material of the present invention may be formed on a film by a known method such as extrusion molding or the like and then cured to form an insulating film.

The insulating film of the present invention includes the vinyl polymer of the present invention and thus the insulating film contains few functional groups of carboxylic acid, and a field effect transistor has no influence of trapping of electrons/carriers of a semiconductor, thereby producing an element having good transistor characteristics and causing excellent solvent resistance. Therefore, the insulating film is suitable for an element forming method.

(Film formation on substrate)

A known commonly-used method may be used as a method for developing the resin composition for insulating materials of the present invention on a substrate, and examples of an application method include a spray method, a spin coating method, a dipping method, a roll coating method, a blade coating method, a doctor roll method, a doctor blade method, a curtain coating method, a slit coating method, a screen printing method, a letterpress reverse printing method, a gravure printing method, a flexographic method, and the like.

(Substrate)

When the resin composition for insulating materials is formed on a substrate, a material is not particularly limited as long as the resin composition for insulating materials of the present invention can be developed. Examples of the material include quartz, sapphire, glass, optical films, ceramic materials, vapor deposited films, magnetic films, reflective films, metal substrates of Al, Ni, Cu, Cr, Fe, stainless, and the like, a screen mesh, paper, wood, synthetic resins such as silicone, SOG (Spin On Glass), polymer substrates such as polyester films, polycarbonate films, polyimide films, and the like, a TFT array substrate, light-emitting diode (LED) substrates of sapphire, GaN, and the like, glass and transparent plastic substrates, conductive substrates such as indium tin oxide (ITO), metals, and the like, insulating substrates, semiconductor forming substrates such as silicon, silicon nitride, polysilicon, silicon oxide, amorphous silicon, and the like. These may be light transmissive or non-transmissive.

(Formation of insulating film)

The insulating film is formed on the substrate and then cured by a known commonly-used method to form an insulating film. A curing method may be either photocuring or thermocuring, but photocuring is preferred in view of curing speed. Light used for irradiation may be any light as long as the photopolymerization initiator is caused to react. In particular, from the viewpoint that the photopolymerization initiator easily reacts and curing can be performed at a lower temperature, light at a wavelength of 450 nm or less (active energy rays such as ultraviolet light, electron beams, X-rays, $\gamma$-rays, or the like) is preferred. In view of operationality, light at a wavelength of 200 to 450 nm is particularly preferred. In the case of thermocuring, 300°C or less is preferred and 200°C or less is more preferred from the viewpoint of preventing thermal deterioration and deformation of the substrate. Also, an infrared lamp may be used. The insulating film may be formed directly on the substrate on an intended electron member, or the insulating film may be formed on another substrate and then introduced into an intended electron member by transfer or the like.

[Organic field effect transistor]

The insulating film of the present invention can be used for various electron members. In particular, the insulating film can be used for an organic field effect transistor, and particularly preferably used as a gate insulating film. The configuration of an organic field effect transistor of the present invention is not particularly limited as long as the insulating film is used. The insulating film can be applied to known commonly-used type transistors such as a bottom gate-top contact type, a bottom gate-bottom contact type, a top gate-top contact type, a top gate-bottom contact type, and the like. For example, Figs. 1 and 2 show configuration examples of an organic field effect transistor using the gate insulating film of the present invention.

In each of the examples shown in Figs. 1 and 2, an organic field effect transistor of the present invention includes a gate electrode 2 formed on a substrate 1, and the gate electrode 2 is covered with a gate insulating film 3 of the present invention. In the example of a bottom gate-bottom contact type shown in Fig. 1, a source electrode 4 and a drain electrode 4 are disposed on the gate insulating film 3, and a semiconductor layer 5 is formed so as to cover these electrodes. On the other hand, in the example of a bottom gate-top contact type shown in Fig. 2, a semiconductor layer 5 is formed on a gate insulating film 3, and a source electrode 4 an a drain electrode 4 are disposed thereon.

Examples of an electrode material (the gate electrode, the source electrode, and the drain electrode) used in the organic field effect transistor of the present invention include metals such as gold, silver, copper, aluminum, calcium, chromium, nickel, titanium, iron, palladium, zinc, tin, lead, indium, and the like; alloys and oxides of these metals; inorganic materials such as carbon black, fullerenes, carbon nanotubes, and the like; and organic $\pi$ conjugated polymers such as polythiophene, polyaniline, polypyrrole, polyfluorene, and derivatives thereof.

These electrode materials may be used alone or may be used in combination of a plurality of materials for improving the mobility and on/off ratio of the organic field effect transistor or controlling the threshold voltage. In addition, the gate electrode, the source electrode, and the drain electrode may be formed by using different electrode materials.

Vacuum vapor deposition, sputtering, or the like is generally used as a method for forming the electrodes, but a method for forming the electrodes by an application method such as a spray coating method, a printing method, an ink jet method, or the like is proposed for simplifying a manufacturing method. In recent years, an application method including partially changing the surface energy of a gate insulating film by ultraviolet irradiation to form a high-definition electrode pattern has been proposed. Examples of applicable electrode materials include nano-metal fine particles, organic $\pi$ conjugated polymers, and the like.

When an electrode is formed by the application method, water and various alcohols are preferred as a solvent for nano-metal ink and organic $\pi$ conjugated polymers because of little damage (inter-mixing) to the gate insulating film of the present invention. In view of excellent solubility of the electrode materials, other preferred solvents include polar solvents such as N,N-dimethylformamide, N,N-dimethylacetamide, 2-pyrrolidone, N-methyl-2-pyrrolidone, N-ethyl-2-pyrrolidone, N-vinyl-2-pyrrolidone, N-methylcaprolactam, dimethyl sulfoxide, tetramethyl urea, and the like. These are preferably used within a range where the gate insulating film of the present invention is little damaged.

A material of the semiconductor layer contained in the organic field effect transistor of the present invention is not particularly limited as long as the layer can be formed on the gate insulating film of the present invention, on the above-described electrodes, and on the above-described plastic substrate. Specific examples thereof include pentacene, oligothiophene derivatives, chalcogen condensed compound derivatives such as [1]benzothieno[3,2-b][1]benzothiophene (BTBT), organic low-molecular materials such as phthalocyanine derivatives, $\pi$ conjugated polymers such as polythiophene derivatives, polyphenylene vinylene derivatives, polyfluorene derivatives, and the like, and oxide semiconductors such as InGaZnO-based, InGaO-based, ZnGaO-based, and InZnO-based semiconductors, ZnO, $SnO_2$, and the like.

A sputtering method, a vacuum vapor deposition method, an ink jet method, a spray method, or the like can be used as a method for forming the semiconductor material. In particular, an application method such as an ink jet method, a spray method, or the like is preferred because it is simple and can decrease the manufacturing cost.

In film formation, a solvent of the material used for the semiconductor layer is not particularly limited as long as it can dissolve or uniformly disperse the material and causes little damage (inter mixing) to the gate insulating film of the present invention, and examples thereof include ortho-dichlorobenzene, xylene, trichlorobenzene, trimethylbenzene, and the like.

EXAMPLES

Next, the present invention is described in detail below with reference to examples and comparative examples. In the examples, "parts" and "%" are on a mass basis unless otherwise specified.

The acid value of the vinyl polymer of the present invention was determined from the acid value of a solid which was produced by reprecipitation by adding dropwise 20 g of a resin composition for insulating materials prepared in a synthesis example below to 1 L of methanol and then filtering and drying the resultant precipitate. Specifically, the acid

value was measured by a method including dissolving a weighed solid in a solvent at a volume ratio of toluene/methanol = 70/30, adding few droplets of a 1% phenolphthalein alcohol solution to the resultant solution, and confirming a point of color change by adding dropwise a 0.1 mol/L potassium hydroxide alcohol solution to the mixture. The acid value was determined by a calculation formula below.

$$\text{Acid value (mgKOH/g) of vinyl polymer} = (V \times F \times 5.611)/S$$

V: Amount (mL) of 0.1 mol/L potassium hydroxide alcohol solution used
F: Titer of 0.1 mol/L potassium hydroxide alcohol solution
S: Amount (g) of sample collected
5.611: Potassium hydroxide equivalent (mg) in 1 mL of 0.1 mol/L potassium hydroxide alcohol solution

A nonvolatile content in a synthesis example was determined by a calculation formula described below from the mass of the weighed resin composition for insulating materials after drying at 120°C for 1 hour in a fan dryer.

$$\text{Nonvolatile content (\%)} = (W2/W1) \times 100$$

W1: Mass (g) of a sample before drying
W2: Mass (g) after drying at 120°C for 1 hour

The acid value of the nonvolatile content in the resin composition for insulating materials of a synthesis example was determined as follows. First, the resin composition for insulating materials prepared in a synthesis example below was weighed in a flask and dissolved a mixed solvent at toluene/methanol = 70/30 (volume ratio) to prepare a measurement solution. Next, a few drops of a 1% phenolphthalein alcohol solution as an indicator were added to the resultant solution, then titration was performed with a 0.1 mol/L potassium hydroxide alcohol solution, and the acid value was calculated by a formula below using a point of color change as an end point. The acid value of the nonvolatile content represents the acid value of a component not evaporated under the conditions of 120°C and 1 hour, and the nonvolatile content contains, besides the vinyl polymer, unreacted monomers used in synthesis and the residual polymerization initiator and additives.

$$\text{Acid value of nonvolatile content (mgKOH/g)} = (A/N) \times 100$$

A: Acid value of resin composition for insulating materials (mgKOH/g)
N: Nonvolatile content in resin composition for insulating materials (%)

In the present invention, a weight-average molecular weight and a number-average molecular weight were determined by gel permeation chromatography (GPC) measurement under conditions described below.

Pump: Waters 600 controller
Column: four connected columns of Shodex LF-804
RI detector: Waters 2414
Data processing: Waters Empower 2
Measurement conditions:

Column temperature: 40°C
Solvent: tetrahydrofuran
Flow rate: 1.0 ml/min

Standard: polystyrene
Sample: prepared by filtering a 0.4 weight% tetrahydrofuran solution in terms of resin solid with a microfilter.

[Synthesis of resin composition for insulating materials containing vinyl polymer]

(SYNTHESIS EXAMPLE 1)

In a reactor provided with a stirrer, a condenser, a dropping funnel, and a nitrogen inlet tube, 110 g of methyl isobutyl ketone (hereinafter referred to as "MIBK") was charged and heated under stirring until the temperature in the system was 100°C. Next, a mixed solution containing 72 g of styrene, 108 g of glycidyl methacrylate (hereinafter referred to as "GMA"), and 7.2 g of tert-butylperoxyethyl hexanoate (hereinafter referred to as "P-O") was added dropwise to MIBK from the dropping funnel over 4 hours, and then the resultant mixture was held at 100°C for 6 hours. Next, the temperature was decreased to 70°C, the nitrogen inlet tube was replaced by an air inlet tube, and then 0.2 g of methoquinone and 54.8 g of acrylic acid were charged. Then, 1.1 g of triphenylphosphine was added, and then the temperature was further increased to 100°C under air bubbling and maintained for 8 hours. Then, after cooling, MIBK was added so that the nonvolatile content was 50%, thereby preparing a resin composition (A) for insulating materials.

Charging of vinyl polymer: 72 g of styrene (I), 108 g of glycidyl methacrylate (II), and 54.8 g of acrylic acid (III)
Acid value of nonvolatile content in the resin composition for insulating materials: 2.0 mgKOH/g
Acid value of vinyl polymer: 0.4 mgKOH/g
Acryloyl group equivalent calculated from charging ratio: 310 g/eq
Weight-average molecular weight: 28,000

(SYNTHESIS EXAMPLE 2)

In a reactor provided with a stirrer, a condenser, a dropping funnel, and a nitrogen inlet tube, 95 g of MIBK was charged and heated under stirring until the temperature in the system was 100°C. Next, a mixed solution containing 126 g of styrene, 54 g of GMA, and 3.6 g of P-O was added dropwise to MIBK from the dropping funnel over 4 hours, and then the resultant mixture was held at 100°C for 6 hours. Next, the temperature was decreased to 70°C, the nitrogen inlet tube was replaced by an air inlet tube, and then 0.2 g of methoquinone and 27.4 g of acrylic acid were charged. Then, 1.1 g of triphenylphosphine was added, and then the temperature was further increased to 100°C under air bubbling and maintained for 8 hours. Then, after cooling, MIBK was added so that the nonvolatile content was 50%, thereby preparing a resin composition (B) for insulating materials.

Charging of vinyl polymer: 126 g of styrene (I), 54 g of glycidyl methacrylate (II), and 27.4 g of acrylic acid (III)
Acid value of nonvolatile content in the resin composition for insulating materials: 1.8 mgKOH/g
Acid value of vinyl polymer: 0.6 mgKOH/mg
Acryloyl group equivalent calculated from charging ratio: 550 g/eq
Weight-average molecular weight: 59,000

(SYNTHESIS EXAMPLE 3)

In a reactor provided with a stirrer, a condenser, a dropping funnel, and a nitrogen inlet tube, 95 g of MIBK was charged and heated under stirring until the temperature in the system was 100°C. Next, a mixed solution containing 108 g of styrene, 72 g of GMA, and 3.6 g of P-O was added dropwise to MIBK from the dropping funnel over 4 hours, and then the resultant mixture was held at 100°C for 6 hours. Next, the temperature was decreased to 70°C, the nitrogen inlet tube was replaced by an air inlet tube, and then 0.2 g of methoquinone and 36.5 g of acrylic acid were charged. Then, 1.1 g of triphenylphosphine was added, and then the temperature was further increased to 100°C under air bubbling and maintained for 8 hours.

Then, after cooling to 80°C, 54.3 g phenyl isocyanate and 0.1 g n-butyltin dilaurate were added and the resultant mixture was maintained for 6 hours. After cooling, MIBK was added so that the nonvolatile content was 50%, thereby preparing a resin composition (C) for insulating materials.

Charging of vinyl polymer: 108 g of styrene (I), 72 g of glycidyl methacrylate (II), and 36.5 g of acrylic acid (III)
Acid value of nonvolatile content in the resin composition for insulating materials: 2.3 mgKOH/g
Acid value of vinyl polymer: 0.3 mgKOH/mg
Acryloyl group equivalent calculated from charging ratio: 540 g/eq
Weight-average molecular weight: 72,000

(SYNTHESIS EXAMPLE 4)

In a reactor provided with a stirrer, a condenser, a dropping funnel, and a nitrogen inlet tube, 167 g of propylene glycol monomethyl ether acetate (hereinafter referred to as "PGM-AC") was charged and heated under stirring until the temperature in the system was 100°C. Next, a mixed solution containing 150 g of benzyl methacrylate, 108 g of GMA, and 5 g of P-O was added dropwise to PGM-AC from the dropping funnel over 4 hours, and then the resultant mixture was held at 100°C for 6 hours. Next, the temperature was decreased to 70°C, the nitrogen inlet tube was replaced by an air inlet tube, and then 0.2 g of methoquinone and 49.7 g of acrylic acid were charged. Then, 1.5 g of triphenylphosphine was added, and then the temperature was further increased to 100°C under air bubbling and maintained for 11 hours. Processing of the reaction was confirmed by a decrease in acid value. Then, after cooling, PGM-AC was added so that the nonvolatile content was 50%, thereby preparing a resin composition (D) for insulating materials.

Charging of vinyl polymer: 150 g of benzyl acrylate (I), 108 g of glycidyl methacrylate (II), and 49.7 g of acrylic acid (III)
Acid value of nonvolatile content in the resin composition for insulating materials: 1.6 mgKOH/g
Acid value of vinyl polymer: 0.2 mgKOH/mg
Acryloyl group equivalent calculated from charging ratio: 430 g/eq
Weight-average molecular weight: 30,000

(SYNTHESIS EXAMPLE 5)

In a reactor provided with a stirrer, a condenser, a dropping funnel, and a nitrogen inlet tube, 182 g of PGM-AC was charged and heated under stirring until the temperature in the system was 100°C. Next, a mixed solution containing 224.1 g of styrene, 45.9 g of GMA, and 5.4 g of P-O was added dropwise to PGM-AC from the dropping funnel over 4 hours, and then the resultant mixture was held at 100°C for 6 hours. Next, the temperature was decreased to 70°C, the nitrogen inlet tube was replaced by an air inlet tube, and then 0.2 g of methoquinone and 22.6 g of acrylic acid were charged. Then, 1.5 g of triphenylphosphine was added, and then the temperature was further increased to 100°C under air bubbling and maintained for 11 hours. Then, after cooling, PGM-AC was added so that the nonvolatile content was 50%, thereby preparing a resin composition (E) for insulating materials.

Charging of vinyl polymer: 224.1 g of styrene (I), 45.9 g of glycidyl methacrylate (II), and 22.6 g of acrylic acid (III)
Acid value of nonvolatile content in the resin composition for insulating materials: 1.7 mgKOH/g
Acid value of vinyl polymer: 0.3 mgKOH/mg
Acryloyl group equivalent calculated from charging ratio: 930 g/eq
Weight-average molecular weight: 43,000

(SYNTHESIS EXAMPLE 6)

In a reactor provided with a stirrer, a condenser, a dropping funnel, and a nitrogen inlet tube, 167 g of MIBK was charged and heated under stirring until the temperature in the system was 100°C. Next, a mixed solution containing 150 g of styrene, 108 g of GMA, and 5 g of P-O was added dropwise to MIBK from the dropping funnel over 4 hours, and then the resultant mixture was held at 100°C for 6 hours. Next, the temperature was decreased to 70°C, the nitrogen inlet tube was replaced by an air inlet tube, and then 0.2 g of methoquinone and 49.7 g of acrylic acid were charged. Then, 1.5 g of triphenylphosphine was added, and then the temperature was further increased to 100°C under air bubbling and maintained for 11 hours. After cooling, MIBK was added so that the nonvolatile content was 50%, thereby preparing a resin solution. Then, in a reactor provided with a stirrer, a condenser, a dropping funnel, and an air inlet tube, 0.13 g of para-toluene sulfonic acid and 12 g of acetic anhydride were added to 50 g of the resultant resin solution having a nonvolatile content of 50%, and the resultant mixture was heated to 80°C and then held for 8 hours. After cooling, the reaction solution was added dropwise to 2 L of methanol to produce white slurry. Then, the slurry was centrifuged, a supernatant was removed, and then PGM-AC was added to the residue. Then, solvent substitution was performed by using an evaporator to produce a resin composition (F) for insulating materials having a nonvolatile content of 40%.

Charging of vinyl polymer: 150 g of styrene (I), 108 g of glycidyl methacrylate (II), and 49.7 g of acrylic acid (III)
Acid value of nonvolatile content in the resin composition for insulating materials: 0.7 mgKOH/mg
Acid value of vinyl polymer: 0.7 mgKOH/mg
Acryloyl group equivalent calculated from charging ratio: 480 g/eq
Weight-average molecular weight: 49,000

(COMPARATIVE SYNTHESIS EXAMPLE 1)

In a reactor provided with a stirrer, a condenser, a dropping funnel, and a nitrogen inlet tube, 95 g of propylene glycol monomethyl ether was charged and heated under stirring until the temperature in the system was 100°C. Next, a mixed solution containing 136.8 g of styrene, 43.2 g of acrylic acid, and 6.8 g of P-O was added dropwise from the dropping funnel over 4 hours, and then the resultant mixture was held at 100°C for 6 hours. Next, the temperature was decreased to 70°C, the nitrogen inlet tube was replaced by an air inlet tube, and then 0.2 g of methoquinone and 71.0 g of GMA were charged. Then, 1.1 g of triphenylphosphine was added, and then the temperature was further increased to 100°C under air bubbling and maintained for 8 hours. Then, after cooling, propylene glycol monomethyl ether was added so that the nonvolatile content was 50%, thereby preparing a resin composition (G).

Charging of vinyl polymer: 136.8 g of styrene (I), 71.0 g of glycidyl methacrylate (II’), and 43.2 g of acrylic acid (III’)
Acid value of nonvolatile content in the resin composition for insulating materials: 28 mg/KOH
Acid value of vinyl polymer: 26 mgKOH/mg
Acryloyl group equivalent calculated from charging ratio: 500 g/eq
Weight-average molecular weight: 59,000

(EXAMPLE 1)

(Preparation of insulating ink)

The resin composition (A) for insulating materials produced in Synthesis Example 1 was diluted with cyclohexanone so that the solid concentration was 20 wt%, and Irgacure (registered trade name) 907 serving as an initiator was added in an amount of 2 parts relative to the solid content, thereby preparing an insulating ink (A-1).

[Formation of insulating film] The insulating ink (A-1) was added dropwise to a glass substrate (5-cm square, thickness of 0.7 mm) by using a syringe with a filter having a pore size of 0.2 μm, and then applied by a spin coating method. Then, the insulating ink was heated at 80°C for 10 minutes in an oven. Then, UV irradiation was performed 2 times with a 120 kW high-pressure mercury lamp in a nitrogen atmosphere by using a conveyer-type UV irradiation apparatus (UB044-5AM-4 manufactured by Eye Graphics Co., Ltd.) at a conveyer speed of about 5 m/min, thereby producing the glass substrate with a resin having a thickness of about 700 nm. In this example, an amount of UV irradiation was 1,000 $mJ/cm^2$, and the irradiation time was about 30 seconds.

(Evaluation of solvent resistance)

A few drops of o-dichlorobenzene were dropped on the resultant glass substrate with the resin by using a syringe, allowed to stand in air at room temperature for 30 minutes, and then heat-treated at 80°C for 30 minutes in an oven. The solvent resistance of the glass substrate with the resin was visually evaluated. The result is shown in Table 1. The surface of the resin was not changed and high solvent resistance to o-dichlorobenzene was exhibited, thereby exhibiting suitability for manufacture of a transistor module by a printing method.

(Insulation evaluation)

The insulating ink (A-1) was added dropwise to a glass substrate (2.5-cm square, thickness of 1 mm) with chromium by using a syringe with a filter having a pore size of 0.2 μm, and then applied by a spin coating method. Then, the organic solvent was evaluated by heat treatment at 80°C for 10 minutes in an oven. Then, UV irradiation curing was performed under the same conditions as in solvent resistance evaluation, thereby producing the glass substrate coated with a resin having a thickness of about 700 nm. Next, gold was deposited to the surface of the glass substrate to produce a laminate including glass/chromium/resin/gold. Then, current-voltage measurement of the resultant substrate was performed. In detail, the voltage between gold and chromium was changed in 2-V steps from 0 to 400 V, the voltage was kept for 1 second until the current was sufficiently stabilized, and then the current value was measured. With respect to the leak current density, current densities at 1 MV/cm and 2MV/cm were measured. In addition, the breakdown voltage was evaluated as a voltage at which the leak current density was rapidly increased. The measurement was performed by using a semiconductor parameter analyzer, product name "SCS4200" manufactured by Keithley Co., Ltd. The results are shown in Table 1. The leak current densities at the applied voltages of 1 MV/cm and 2 MV/cm were $1 \times 10^{-8}$ $A/cm^2$ or less, and the breakdown voltage was as high as 3 MV/cm or more, thereby exhibiting good insulation.

[Transistor characteristic evaluation 1]

The insulating ink (A-1) was added dropwise to a patterned glass substrate (5-cm square, thickness of 0.7 mm) using chromium as a gate electrode by using a syringe with a filter having a pore size of 0.2 μm, and then applied by a spin coating method. Then, the insulating ink was heat-treated at 80°C for 10 minutes in an oven. Then, UV irradiation curing was performed under the same conditions as in solvent resistance evaluation, thereby producing a gate insulating film having a thickness of about 700 nm. Since the gate insulating film can be cured for about 30 seconds, the curing rate is considered to be suitable for a printing method.

Next, gold was deposited to a thickness of 40 nm on the gate insulating film, and source/drain electrodes having a channel length L of 100 μm and a channel width W of 2 mm were formed.

Further, poly(3-hexyl)thiophene (manufactured by Merck KGaA, weight-average molecular weight of about 50000, referred to as "P3HT" hereinafter) was dissolved at a concentration of 0.5% by mass in o-dichlorobenzene to prepare a coating solution of P3HT. The coating solution was applied to the gate insulating film and the source/drain electrodes by a dispenser. Then, in order to completely evaporate the solvent and moisture, heat treatment was performed in a nitrogen atmosphere or at 150°C for 15 minutes in an oven to form a semiconductor layer, thereby completing an organic transistor. A cross-sectional view of an organic thin-film transistor shown in Fig. 1 corresponds to an organic transistor of Example 1.

The drain current and gate voltage of the organic transistor produced as described above were evaluated as electric characteristics. In detail, at a source/drain voltage (VD) of -40 V, the gate voltage (VG) was changed in 2-V steps from +40 V to -80 V, and a value after the voltage was kept for 1 second until the current was sufficiently stabilized was recorded as a measured value of the drain current. The measurement was performed by using a semiconductor parameter analyzer, product name "SCS4200" manufactured by Keithley Co., Ltd.

The drain current ID in a saturated state can be generally represented by a formula below. That is, mobility μ of an organic semiconductor can be determined from a gradient of a graph in which a square root of absolute value of drain current ID is plotted on the ordinate, and gate voltage VG is plotted on the abscissa.

$$ID = W \times C \times \mu \times (VG - VT)^2/2L$$

In the formula above, W: the channel width of a transistor, L: the channel length of a transistor, C: capacitance of a gate insulating film, VT: threshold voltage of a transistor, and μ: mobility. As a result of calculation of mobility μ of P3HT based on the formula, mobility was $2 \times 10^{-3}$ $cm^2/Vs$. Also, the threshold voltage was +9 V, and the ON state/OFF state ratio (ON/OFF ratio) was the order of $10^4$. The results are shown in Table 2. In addition, hysteresis was not observed. The organic transistor was evaluated in a nitrogen atmosphere. That is, it was shown that the gate insulating film formed using the insulating ink (A-1) can be applied as a gate insulating film for an organic transistor.

[Transistor characteristic evaluation 2]

Electrodes up to the source/drain electrodes were formed by the same method as for the transistor characteristics 1. Further, a BTBT derivative having a structure described below and produced by a method described in International Publication No. WO2008/04789 pamphlet was dissolved at a concentration of 0.5% by mass in o-dichlorobenzene to prepare a coating solution. The coating solution was applied to the gate insulating film and the source/drain electrodes by a dispenser. Then, in order to completely evaporate the solvent and moisture, heat treatment was performed at 150°C for 15 minutes in a nitrogen atmosphere in an oven to form a semiconductor layer, thereby completing an organic transistor.

[Chem. 1]

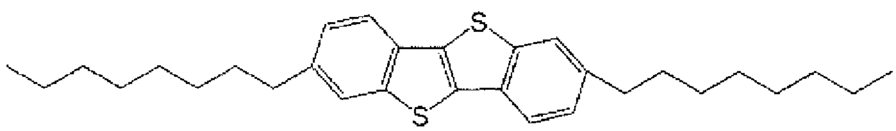

The drain current and gate voltage of the organic transistor produced as described above were evaluated as electric characteristics. In detail, at a source/drain voltage (VD) of -40 V, the gate voltage (VG) was changed in 2-V steps from +40 V to -80 V, and a value after the voltage was kept for 1 second until the current was sufficiently stabilized was recorded as a measured value of the drain current. The measurement was performed by using a semiconductor parameter

analyzer, product name "SCS4200" manufactured by Keithley Co., Ltd. Mobility calculated by the same method as for the transistor characteristics evaluation 1 was $3 \times 10^{-2}$ $cm^2/Vs$. Also, the threshold voltage was -3 V, and the ON state/OFF state ratio (ON/OFF ratio) was the order of $10^4$. The organic transistor was evaluated in an air atmosphere. In addition, as a result of measurement of mobility after the transistor was allowed to stand in air for 1 month, the mobility was $2 \times 10^{-2}$ $cm^2/Vs$. The results are shown in Table 3. That is, it was shown that the gate insulating film formed using the composition A can be applied as a gate insulating film for an organic transistor with reliability.

(EXAMPLE 2)

The resin composition (B) for insulating materials produced in Synthesis Example 2 and 5 parts of dipentaerythritol hexaacrylate (manufactured by Toagosei Co., Ltd., Aronix (registered trade name) M-402) were diluted with cyclohexanone so that the solid concentration was 20 wt%, and Irgacure 907 serving as an initiator was added in an amount of 2 parts relative to the solid content, thereby producing an insulating ink (B-1).

The solvent resistance test, insulation evaluation, transistor evaluation 1, and transistor evaluation 2 were performed by using the resultant insulating ink (B-1) according to the same methods as in Example 1. The results are shown in Tables 1, 2, and 3. Like in Example 1, good solvent resistance and insulation were exhibited. Also, hysteresis was not observed in transistor evaluation, and good mobility and storage stability were exhibited.

(EXAMPLE 3)

A solution of the resin composition (C) for insulating materials produced in Synthesis Example 3 and 10 parts of dipentaerythritol hexaacrylate (manufactured by Toagosei Co., Ltd., Aronix (registered trade name) M-402) were diluted with cyclohexanone so that the solid concentration was 20 wt%, and Irgacure 907 serving as an initiator was added in an amount of 2 parts relative to the solid content, thereby producing an insulating ink (C-1).

The solvent resistance test, insulation evaluation, transistor evaluation 1, and transistor evaluation 2 were performed by using the resultant insulating ink (C-1) according to the same methods as in Example 1. The results are shown in Tables 1, 2, and 3.

Like in Example 1, good solvent resistance and insulation were exhibited. Also, hysteresis was not observed in transistor evaluation, and good mobility and stability were exhibited.

(EXAMPLE 4)

The resin composition (D) for insulating materials produced in Synthesis Example 4 was diluted with PGM-AC so that the solid concentration was 12 wt%, and Irgacure 2959 serving as an initiator was added in an amount of 2 parts relative to the solid content, thereby producing an insulating ink (D-1).

The solvent resistance test, insulation evaluation, and transistor evaluation 2 were performed by using the resultant insulating ink (D-1) according to the same methods as in Example 1. The results are shown in Tables 1 and 3. Like in Example 1, good solvent resistance and insulation were exhibited. Also, hysteresis was not observed in transistor evaluation, and good mobility and stability were exhibited.

(EXAMPLE 5)

The resin composition (E) for insulating materials produced in Synthesis Example 5 and 50 parts of pentaerythritol tetraacrylate (manufactured by Toagosei Co., Ltd., Aronix (registered trade name) M-305) relative to the vinyl polymer (E) were diluted with PGM-AC so that the solid concentration was 10 wt%, and Irgacure 907 serving as an initiator was added in an amount of 2 parts relative to the solid content, thereby producing an insulating ink (E-1).

The solvent resistance test, insulation evaluation, and transistor evaluation 2 were performed by using the resultant insulating ink (E-1) according to the same methods as in Example 1. The results are shown in Tables 1 and 3.

Like in Example 1, hysteresis was not observed in transistor evaluation.

(EXAMPLE 6)

The resin composition (F) for insulating materials produced in Synthesis Example 6 and 20 parts of isocyanuric acid EO-modified triacrylate (manufactured by Toagosei Co., Ltd., Aronix (registered trade name) M-315) relative to the vinyl polymer (F) were diluted with PGM-AC so that the solid concentration was 11 wt%, and Irgacure 907 serving as an initiator was added in an amount of 2 parts relative to the solid content, thereby producing an insulating ink (F-1).

The solvent resistance test, insulation evaluation, and transistor evaluation 2 were performed by using the resultant insulating ink (F-1) according to the same methods as in Example 1. The results are shown in Tables 1 and 3.

Like in Example 1, good solvent resistance and insulation were exhibited. Also, hysteresis was not observed in transistor evaluation, and good mobility and stability were exhibited.

(COMPARATIVE EXAMPLE 1)

The resin composition (G) for insulating materials produced in Comparative Synthesis Example 1 was diluted with cyclohexanone so that the solid concentration was 20 wt%, and Irgacure 907 serving as an initiator was added in an amount of 2 parts relative to the solid content, thereby producing an insulating ink (G-1).

The solvent resistance test and insulation evaluation were performed by using the resultant insulating ink (G-1) according to the same methods as in Example 1. The results are shown in Table 1. Insulation was good, but as a result of the solvent resistance test, solvent resistance to o-dichlorobenzene was not exhibited. It was thus found that the insulating ink is not suitable for manufacturing a transistor module by a printing method.

(COMPARATIVE EXAMPLE 2)

Acrylic resin (manufactured by DIC Corporation, Acrylic (registered trade name) 198) was dissolved with toluene so that the solid content was 13 wt%, producing an insulating ink (H-1).

(Solvent resistance test)

The solvent resistance test and insulation evaluation were performed by the same methods as in Example 1 except that the insulating ink (H-1) was used and the organic solvent was evaporated by heat treatment under coating film formation conditions of 80°C and 60 minutes. The results are shown in Table 1. As a result of the solvent resistance evaluation, solvent resistance was not exhibited. It was thus found that the insulating ink is not suitable for manufacturing a transistor module by a printing method.

(Insulation evaluation)

The insulating ink (G-1) was added dropwise to a glass substrate (2.5-cm square, thickness of 1 mm) with chromium by using a syringe with a filter having a pore size of 0.2 um, and then applied by a spin coating method. Then, the organic solvent was evaluated by heat treatment at 80°C for 60 minutes in an oven, thereby producing the glass substrate coated with a resin having a thickness of about 700 nm. Next, gold was deposited on the surface of the glass substrate to produce a laminate including glass/chromium/resin/gold. Then, current-voltage measurement of the resultant substrate was performed. The result is shown in Table 1.

(COMPARATIVE EXAMPLE 3)

The resin composition (G) produced in Synthesis Example 3 and 20 parts of dipentaerythritol hexaacrylate (manufactured by Toagosei Co., Ltd., Aronix (registered trade name) M-402) relative to the vinyl polymer (G) were diluted with cyclohexanone so that the solid concentration was 20 wt%, and Irgacure 907 serving as an initiator was added in an amount of 2 parts relative to the solid content, thereby producing an insulating ink (G-2).

The solvent resistance test, insulation evaluation, transistor evaluation 1, and transistor evaluation 2 were performed by using the resultant insulating ink (G-2) according to the same methods as in Example 1. The results are shown in Tables 1, 2, and 3. Like in Example 1, hysteresis was not observed in transistor evaluation. As a result of transistor characteristic evaluations 1 and 2, low mobility and large decrease in mobility 1 month after were exhibited, and reliability was not satisfactory as compared with Examples 1, 2, 3, 4, 5, and 6.

[Table 1]

| Table 1 Evaluation results of insulation and solvent resistance | | | | |
|---|---|---|---|---|
| | Leak current density (A/$cm^2$) | | Breakdown voltage (MV/cm) | Solvent resistance |
| | 1MV/cm | 2MV/cm | | |
| Example 1 | $5\times10^{-10}$ | $2\times10^{-10}$ | 3< | No deterioration |
| Example 2 | $3\times10^{-10}$ | $1\times10^{-9}$ | 3< | No deterioration |
| Example 3 | $2\times10^{-10}$ | $1\times10^{-9}$ | 3< | No deterioration |

(continued)

| Table 1 Evaluation results of insulation and solvent resistance | | | | |
|---|---|---|---|---|
| | Leak current density (A/cm$^2$) | | Breakdown voltage (MV/cm) | Solvent resistance |
| | 1MV/cm | 2MV/cm | | |
| Example 4 | $3\times10^{-10}$ | $2\times10^{-9}$ | 3< | No deterioration |
| Example 5 | $2\times10^{-10}$ | $1\times10^{-10}$ | 3< | No deterioration |
| Example 6 | $2\times10^{-10}$ | $9\times10^{-9}$ | 3< | No deterioration |
| Comparative Example 1 | $3\times10^{-10}$ | $2\times10^{-9}$ | 3< | Clouded |
| Comparative Example 2 | $2\times10^{-10}$ | $1\times10^{-10}$ | 3< | Clouded |
| Comparative Example 3 | $2\times10^{-9}$ | $1\times10^{-9}$ | 3< | No deterioration |

Table 1 indicates that the insulating films formed using the insulating inks of the present invention in Examples 1 to 6 show high solvent resistance and have high insulation as compared with Comparative Examples 1 and 2.

[Table 2]

| Table 2 Results of transistor characteristic evaluation 1 (using P3HT as organic semiconductor) | | |
|---|---|---|
| | Mobility | Threshold voltage |
| | cm$^2$/Vs | V |
| Example 1 | $2\times10^{-3}$ | +9 |
| Example 2 | $3\times10^{-3}$ | +8 |
| Example 3 | $2\times10^{-2}$ | +6 |
| Comparative Example 3 | $5\times10^{4}$ | +12 |

Table 2 indicates that the transistors produced using the insulating inks of the present invention in Examples 1 to 3 have high mobility and low threshold voltage as compared with Comparative Example 3, and thus the gate insulating film provides excellent transistor characteristics.

[Table 3]

| Table 3 Results of transistor characteristic evaluation 2 (using BTBT derivative as organic semiconductor) | | |
|---|---|---|
| | Immediately after transistor manufacture | 1 month after |
| | Mobility | Mobility |
| | cm$^2$/Vs | cm$^2$/Vs |
| Example 1 | $3\times10^{-2}$ | $2\times10^{-2}$ |
| Example 2 | $3\times10^{-2}$ | $4\times10^{-2}$ |
| Example 3 | $1\times10^{-1}$ | $1\times10^{-1}$ |
| Example 4 | $5\times$10-2 | $4\times10^{-2}$ |
| Example 5 | $9\times10^{-2}$ | $8\times10^{-2}$ |
| Example 6 | $1\times10^{-1}$ | $3\times10^{-1}$ |
| Comparative Example 3 | $5\times10^{-3}$ | $1\times10^{4}$ |

Table 3 indicates that the transistors produced using the insulating inks of the present invention in Examples 1 to 6 have high mobility and small decrease in mobility 1 month after as compared with Comparative Example 3, and thus the gate insulating film provides a transistor having excellent reliability.

Industrial Applicability

A resin composition for insulating materials and an insulating film according to the present invention can be preferably used for various electronic members such as a gate insulating film for thin-film transistors and an interlayer insulating film for semiconductors. Reference Signs List

1 support (substrate)
2 gate electrode
3 insulating layer (gate insulating film)
4 source/drain electrode
5 organic semiconductor film (layer)

## Claims

**1.** A resin composition for insulating materials, comprising a vinyl polymer,
wherein the vinyl polymer has an acid value of 20 mgKOH/g or less, a (meth)acryloyl group equivalent of 220 to 1600 g/eq, and phenyl groups and (meth)acryloyl groups.

**2.** The resin composition for insulating materials according to Claim 1, wherein the vinyl polymer is produced by reacting an epoxy group of a copolymer of a phenyl group-containing vinyl monomer (I) and an epoxy group-containing vinyl monomer (II) with a monomer (III) having a (meth)acryloyl group and a carboxyl group.

**3.** The resin composition for insulating materials according to Claim 1 or 2, wherein the weight-average molecular weight of the vinyl polymer is 3,000 to 200,000.

**4.** A method for producing a resin composition for insulating materials containing a vinyl polymer, the method comprising:

1. a step of producing a copolymer by copolymerizing a phenyl group-containing vinyl monomer (I) with an epoxy group-containing vinyl monomer (II), and
2. a step of reacting an epoxy group of the resultant copolymer with a monomer (III) having a (meth)acryloyl group and a carboxyl group.

**5.** An insulating ink comprising the resin composition for insulating materials according to any one of Claims 1 to 3.

**6.** A cured product produced by curing the resin composition for insulating materials according to any one of Claims 1 to 3.

**7.** An insulating film for an organic field effect transistor, the insulating film being produced by curing the resin composition for insulating materials according to any one of Claims 1 to 3.

**8.** The insulating film according to Claim 7, wherein the insulating film is a gate insulating film.

**9.** An organic field effect transistor comprising the insulating film according to Claim 7.

FIG. 1

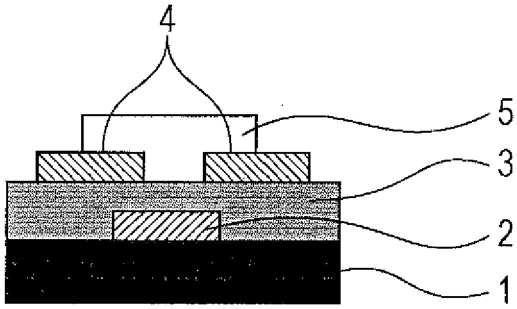


FIG. 2

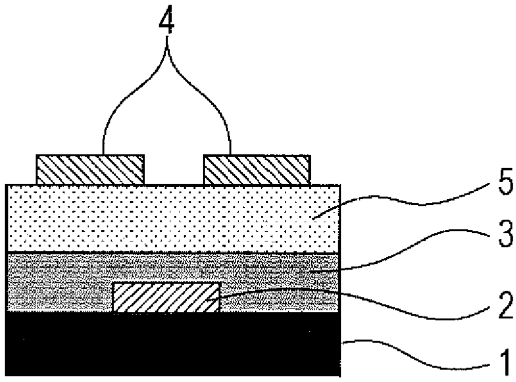

**INTERNATIONAL SEARCH REPORT**

International application No. PCT/JP2014/052745

A. CLASSIFICATION OF SUBJECT MATTER
*H01B3/30*(2006.01)i, *C08F8/00*(2006.01)i, *C08F290/12*(2006.01)i, *C08F299/00*(2006.01)i, *C09D11/00*(2014.01)i, *C09D157/00*(2006.01)i, *H01B3/44*(2006.01)i, *H01L29/786*(2006.01)i, *H01L51/05*(2006.01)i, *H01L51/30*(2006.01)i

According to International Patent Classification (IPC) or to both national classification and IPC

B. FIELDS SEARCHED

Minimum documentation searched (classification system followed by classification symbols)
H01B3/30, C08F8/00, C08F290/12, C08F299/00, C09D11/00, C09D157/00, H01B3/44, H01L29/786, H01L51/05, H01L51/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2009-86376 A (Fujifilm Corp.),<br>23 April 2009 (23.04.2009),<br>claims; paragraphs [0012] to [0019], [0157] to [0160]; examples<br>& CN 101398623 A & TW 200928581 A | 1,3,5,6<br>2-6<br>7-9 |
| X<br>Y<br>A | WO 2011/142393 A1 (Nissan Chemical Industries, Ltd.),<br>17 November 2011 (17.11.2011),<br>claims; paragraphs [0027] to [0051], [0097]; examples<br>& CN 102933626 A & KR 10-2013-0072218 A<br>& TW 201207031 A | 4<br>2-6<br>1,7-9 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 March, 2014 (14.03.14) | 25 March, 2014 (25.03.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2014/052745

C (Continuation). DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2008-120876 A (Nissan Chemical Industries, Ltd.),<br>29 May 2008 (29.05.2008),<br>claims; paragraphs [0018] to [0038], [0065]; examples<br>(Family: none) | 4<br>2-6<br>1,7-9 |
| A | JP 2010-180306 A (Showa Highpolymer Co., Ltd.),<br>19 August 2010 (19.08.2010),<br>entire text<br>(Family: none) | 1-9 |
| A | JP 2007-224293 A (Samsung Electronics Co., Ltd.),<br>06 September 2007 (06.09.2007),<br>entire text<br>& US 2007/0184293 A1 & KR 10-2007-0079682 A<br>& CN 101058618 A | 1-9 |

Form PCT/ISA/210 (continuation of second sheet) (July 2009)

**INTERNATIONAL SEARCH REPORT**

International application No.
PCT/JP2014/052745

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet.

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee.
☐ The additional search fees were accompanied by the applicant's protest but the applicable protest fee was not paid within the time limit specified in the invitation.
☐ No protest accompanied the payment of additional search fees.

Form PCT/ISA/210 (continuation of first sheet (2)) (July 2009)

**INTERNATIONAL SEARCH REPORT**

International application No.
PCT/JP2014/052745

Continuation of Box No.III of continuation of first sheet(2)

The technical feature common to claim 1 and claim 4 is a resin composition for insulating materials, which contains a vinyl polymer having a phenyl group and a (meth)acryloyl group.

However, the above-said technical feature cannot be considered to be a special technical feature, since the technical feature does not make a contribution over the prior art in the light of the contents disclosed in, for example, JP 2009-86376 A.

Further, there is no other same or corresponding special technical feature between these inventions.

Accordingly, claims are classified into two inventions each of which has a special technical feature indicated below.

(Invention 1) claims 1-3 and 5-9

A resin composition for insulating materials, which contains a vinyl polymer and is characterized in that: the vinyl polymer has an acid value of 20 mgKOH/g or less and a (meth)acryloyl group equivalent of 220-1,600 g/eq; and the vinyl polymer has a phenyl group and a (meth)acryloyl group.

(Invention 2) claim 4

A method for producing a resin composition for insulating materials containing a vinyl polymer, which is characterized by comprising: (1) a step wherein a copolymer is obtained by copolymerizing a vinyl monomer (I) having a phenyl group and a vinyl monomer (II) having an epoxy group; and (2) a step wherein the epoxy group of the thus-obtained copolymer is reacted with a monomer (III) that has a (meth)acryloyl group and a carboxyl group.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009059651 A
- JP 2012195580 A
- WO 200804789 A